# EUROPEAN PATENT SPECIFICATION

(11) **EP 3 734 248 B1**
(45) Date of publication and mention of the grant of the patent: **01.09.2021**
(21) Application number: 20166405.9
(22) Date of filing: 27.03.2020
(51) Int. Cl.: G01L 23/10, F02M 57/00

(54) **A HIGH-PRESSURE HYDRAULIC SYSTEM COMPRISING A SENSOR FOR NON-INVASIVE DIAGNOSTICS**
HOCHDRUCKHYDRAULIKSYSTEM MIT EINEM SENSOR FÜR NICHTINVASIVE DIAGNOSTIK
SYSTÈME HYDRAULIQUE HAUTE PRESSION COMPRENANT UN CAPTEUR DE DIAGNOSTIC NON INVASIF

(30) Priority: 29.04.2019 IT 201900006429
(43) Date of publication of application: 04.11.2020
(73) Proprietor: OMT Digital S.r.l., 10122 Torino (IT)
(72) Inventor: COPPO, Marco, 10132 Torino (IT); CATUCCI, Francesco, 70017 Putignano (Bari) (IT); CHIARBONELLO, Lorenzo, 10090 Buttigliera Alta (Torino) (IT); VIOLINO, Andrea, 10040 San Gillio (Torino) (IT)
(74) Representative: Marchitelli, Mauro

(56) References cited:
- EP-A1- 3 001 024
- EP-A1- 3 109 453
- DE-A1-102011 078 947

## Description

### Field of the invention

The present invention relates in general to high pressure hydraulic systems and regards a high-pressure hydraulic system comprising a sensor for non-invasive diagnostics of the operation of the system.

The invention was developed in particular in view of its application to the diagnostics of fuel injection systems for large diesel and dual-fuel engines, for example, for large naval engines. In the following description, reference will be made to this specific field of use without, however, losing generality.

### Description of the prior art

In the field of hydraulic systems, and in particular of high pressure injection systems for Diesel engines, there is a growing interest in the development of diagnostic systems capable of acquiring significant data for the diagnostics of operation of complex systems.

This has prompted the development of low-cost sensors that are able to measure characteristic operating parameters, such as hydraulic pressure.

In the field of fuel injection systems, sensors have been proposed for measuring the force and/or pressure and, in particular, configured for being fixed to a fuel injector for identifying the closing time of the injector needle. For example, EP3001167 describes a sensor assembly comprising at least one sensor element of piezoelectric material with two end faces located parallel to each other and each with an associated electrode, wherein the electrodes, which are electrically insulated from each other, are envisaged to be in contact with the sensor element.

Hydraulic systems have also been proposed in which the sensors are integrated into the components to be monitored (e.g. EP3026254 and EP3034855).

In common-rail fuel injectors, the sensors are often placed in areas adjacent to the hole that carries the fluid from the pressurized accumulator towards a fuel dispensing chamber located upstream of the injector needle sealing area. This allows detection of operating data of the injector, but not of its control valve, since the perturbations it generates during operation do not propagate up to this line.

The ideal position for a pressure sensor for diagnostic purposes would be close to the injector control chamber. However, due to the small size of this area and the high pressures of the fluid present in the control chamber, it would be necessary to use small sensor elements, which are therefore limited in terms of the loads and deformations they can withstand. In general, the problem is that it is necessary to manage deformations generated by very high pressures (in the order of thousands of bars) in small spaces.

US2014027534A1 describes a fuel injector for a common-rail injection system, comprising a piezoelectric pressure sensor to detect pressure variations during the opening and closing of the injection needle, in order to determine the moment of closure of the injector needle. The pressure sensor is arranged in a low pressure region, and is loaded by an axial force produced by the rod of a control valve. The sensor described in US2014027534A1 has the object of detecting the pressure in a chamber located downstream of the control chamber and connected thereto by means of a calibrated orifice. Therefore, the sensor described in this document is unable to directly detect a signal representative of the pressure in the control chamber. In fact, when the valve is open, the pressure read by the sensor is at an intermediate level between the pressure in the control chamber and the discharge pressure, and this level is also determined by the pressure drop across the valve seat. When the valve is closed, the orifice-intermediate chamber system introduces a delay between the pressure signal in the control chamber and the pressure signal detected by the sensor.

EP3109453 A1 discloses a fuel injector having a high-pressure chamber supplied with pressurized fuel via a supply bore. A piezoelectric sensor is housed in a recess of the injector housing facing the supply bore. The sensor is connected to the base and to the circumferential walls of the recess through layers of thermosetting adhesive which create a substantially rigid connection between the sidewalls of the recess and the sidewalls of the sensor element.

DE102011078947 A1 discloses a fuel injector comprising a sensor element made of a piezoelectric material, arranged in a low-pressure region of the fuel injector for detecting pressure changes during opening and closing of the injection needle.

EP3001024 A1 discloses a fuel injector comprising a sensor device for indirect detection of a fuel pressure in the injector housing.

### Object and summary of the invention

The object of the present invention is to provide a high pressure hydraulic system that detects a signal related to the pressure of the fluid inside the hydraulic system, in a cost-effective and non-invasive way.

According to the present invention, this object is achieved by a high pressure hydraulic system having the characteristics forming the subject of claim 1.

The characterizing element of the present invention is the particular arrangement and conformation of sensitive and supporting elements that make up the sensor and that make it possible to integrate it into different hydraulic systems. The electrical signal provided by this sensor can be used to diagnose the operation of the hydraulic system through classic techniques or by means of artificial intelligence.

In particular, in the case of applications in injection systems, the small size, the resistance to high temperatures, and the adaptability to integration in components having different rigidities, make the sensor suitable for detecting the pressure in the control volume of common-rail injectors, from which it is possible to derive a series of operating diagnosis parameters for the entire injector.

The claims form an integral part of the disclosure provided here in relation to the invention.

### Brief description of the drawings

The present invention will now be described in detail with reference to the attached drawings, given purely by way of non-limiting example, wherein:
- Figure 1 is a partial cross-section of an injector for common-rail injection systems,
- Figure 2 is a cross-section on an enlarged scale of the part indicated by the arrow II in Figure 1,
- Figure 3 is a cross-section along the line III-III of Figure 2, and
- Figure 4 is a cross-section along the line IV-IV of Figure 3.

### Detailed description

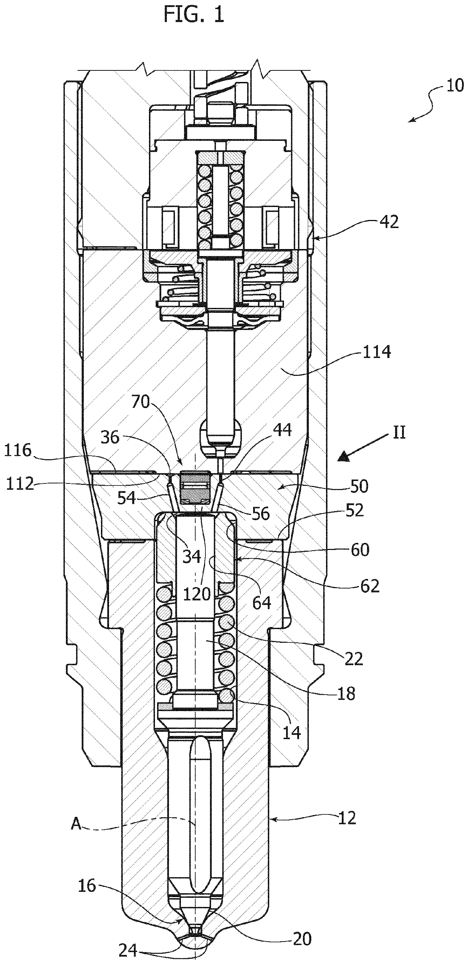

Figure 1 illustrates a high pressure hydraulic system. In the example illustrated, the hydraulic system consists of an injector 10 for a common-rail injection system. The injector 10 comprises a pulverizer 12 having a fuel dispensing chamber 14 having a valve seat 16. An injector needle 18 extends into the dispensing chamber 14, and has a sealing surface 20 which cooperates with the valve seat 16. The injector needle 18 is movable along its longitudinal axis A between a closed position in which the sealing surface 20 abuts against the valve seat 16, and an open position in which the sealing surface 20 is spaced apart from the valve seat 16. A spring 22 tends to push the injector needle 18 towards the closed position. The pulverizer 12 has a plurality of injection holes 24 through which the pressurized fuel located in the dispensing chamber 14 is pulverized when the injector needle 18 is in the open position.

The dispensing chamber 14 is connected to an accumulation volume filled with pressurized fuel coming from a high-pressure pump. The accumulation volume is also connected to a hydraulic chamber 34 via a hydraulic line on which a first calibrated orifice 36 is arranged. The hydraulic chamber 34 is connected to a discharge line which leads to a tank. A control valve 42 is arranged on the discharge line. The control valve 42 is an electrically-controlled two-position valve which - in the open position - connects the hydraulic chamber 34 to the discharge line, and - in the closed position - isolates the hydraulic chamber 34 from the discharge line. A second calibrated orifice 44 is arranged upstream of the control valve 42.

The injector 10 comprises a wall 50 arranged in hydraulic sealing contact with a head surface 52 of the pulverizer 12. The wall 50 encloses at least one part of the hydraulic chamber 34. In the wall 50, the calibrated orifices 36, 44 are formed, which are connected to the hydraulic chamber 34 through respective holes 54, 56 which are also formed in the wall 50.

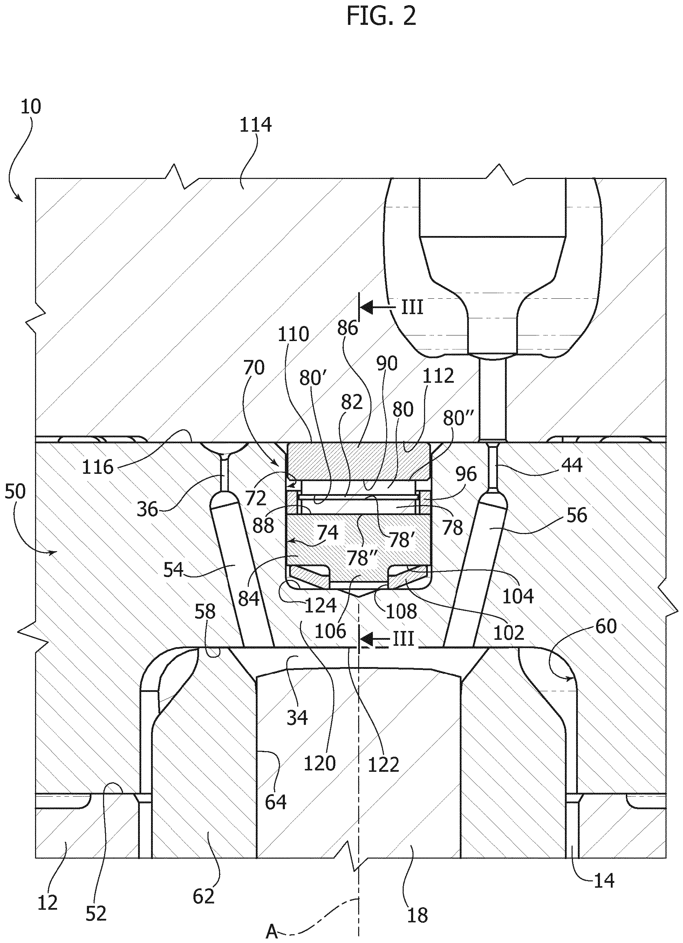

With reference to Figure 2, the wall 50 has a reaction surface 58 against which the pressure of the fluid contained in the hydraulic chamber 34 acts. The holes 54, 56 are open on a part of the reaction surface 58 facing the hydraulic chamber 34. In some embodiments, the hole 54 and the orifice 36 can be exchanged with respect to the arrangement illustrated in Figure 2.

The reaction surface 58 of the wall 50 can be formed in a seat 60 of the wall 50 open towards the dispensing chamber 14 of the pulverizer 12. A bushing 62 is partially housed inside the seat 60 and has a hole 64 in which a head portion of the injector needle 18 slides.

The hydraulic chamber 34 is delimited by the reaction surface 58 of the wall 50, by a head surface 66 of the injector needle 18 and by an annular portion 68 of the guide bushing 62.

With reference to Figures 2, 3 and 4, the injector 10 comprises a piezoelectric sensor 70 which provides an electrical signal indicative of the operation of the injector 10.

The sensor 70 is completely isolated from the pressurized fluid contained in the hydraulic chamber 34. The electrical signal provided by the sensor 70 is indicative of the deformations of the wall 50 generated by the changes in fluid pressure in the hydraulic chamber 34. The piezoelectric sensor 70 is a pressure transducer that provides an electrical signal related to the pressure of the fluid in the hydraulic chamber 34. The sensor 70 has a detection axis A that constitutes the direction along which the sensor 70 is capable of detecting pressure variations. The detection axis A may coincide with the longitudinal axis of the injector 10.

The wall 50 comprises an integral diaphragm 120 formed by a portion with reduced thickness of the wall 50. The diaphragm 120 has a first surface 122 in direct contact with the pressurized fluid contained in the hydraulic chamber 34, and a second surface 124, opposite the first surface 122, which is not in contact with the pressurized fluid contained in the hydraulic chamber 34. The first surface 122 of the diaphragm 120 consists of a portion of the reaction surface 58.

In the illustrated embodiment, the diaphragm 120 is located at the bottom of a blind hole 72 in which the sensor 70 is housed. The blind hole 72 is formed in the wall 50 and has a side surface 74 coaxial with the detection axis A of the sensor 70, and a bottom surface forming the second surface 124 of the diaphragm 120.

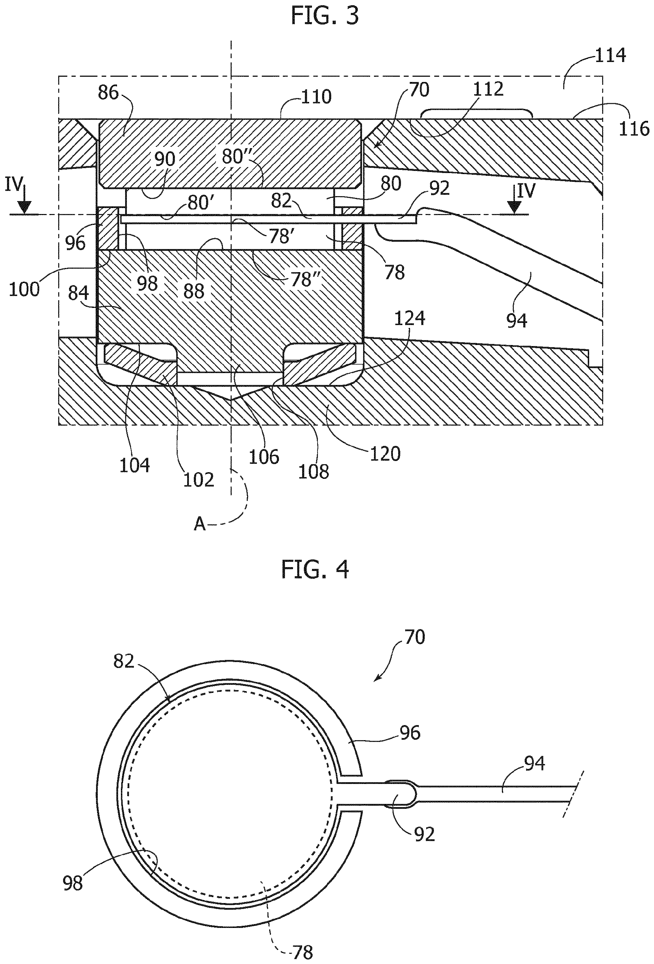

The sensor 70 comprises two disc-shaped elements 78, 80. The two disc-shaped elements 78, 80 have respective first faces 78', 80' and respective second faces 78", 80". The first and second faces 78', 80' and 78", 80" of each of the two disc-shaped elements are plane faces parallel to each other and perpendicular to the detection axis A, which can have a circular shape in a plane perpendicular to the axis A (Figure 4).

At least one of the two disc-shaped elements is a piezoelectric element that - when subjected to a compression load in the direction of the detection axis A - generates an accumulation of positive charges on the first face 78', 80' and negative charges on the second face 78", 80". The amount of electric charges generates a potential difference between the faces 78', 80' and/or 78", 80" which increases proportionally to the pressure increase in the direction of the detection axis A.

In one embodiment, both disc-shaped elements 78, 80 are piezoelectric elements. In this case, the first faces 78', 80' of the disc-shaped elements 78, 80 are positive terminal faces and the second faces 78", 80" of the disc-shaped elements 78, 80 are negative terminal faces.

In a possible variant, only one of the two disc-shaped elements 78, 80 is a piezoelectric element, and the other of the two disc-shaped elements 78, 80 can be an insulating element without piezoelectric properties.

An electrode 82 formed by a thin wall of conductive material is arranged between the two disc-shaped elements 78, 80, said electrode 82 is perpendicular to the detection axis A. The first faces 78', 80' of the two disc-shaped elements 78, 80 are in contact with opposite faces of the electrode 82. The electrode 82 may have a circular shape with a diameter slightly larger than the diameter of the piezoelectric elements 78, 80.

The sensor 70 may comprise two supporting elements 84, 86 of electrically-conductive material. The two supporting elements 84, 86 have respective supporting faces 88, 90 resting against respective second faces 78", 80" of the disc-shaped elements 78, 80. The side walls of the supporting elements 84, 86 can be in contact with the side surface 74 of the hole 72.

The electrode 82 arranged between the two piezoelectric elements 78, 80 constitutes the positive pole of the sensor 70. The negative pole consists of the supports 84, 86 electrically-connected to ground through the wall 50.

With reference to Figures 3 and 4, the electrode 82 may have a protruding portion 92 which extends outwards in a direction perpendicular to the detection axis A, to which one end of an electric cable 94 is connected, on which an analog electrical signal passes whose amplitude is proportional to the force acting between the two supports 84, 86 in the direction of the detection axis A.

The sensor 70 comprises an insulating element 96 with an annular shape, arranged coaxially with the axis A outside the electrode 82. The insulating element 96 has an inner surface 98 facing the outer edges of the disc-shaped elements 78, 80 and of the electrode 82, and which allows the centering between the disc-shaped elements 78, 80 and the electrode 82 with respect to the detection axis A. The insulating element 96 guarantees electrical insulation of the electrode 82 and of the disc-shaped elements 78, 80 from the metal components of the injector. The insulating element 96 has a dimension in the direction of the detection axis A that is less than the distance between the supporting faces 88, 90 of the supporting elements 84, 86, and has a base surface 100 that rests on the outer perimeter part of the face 88 of one supporting element 84.

The sensor 70 is constrained to the wall 50 in the direction of the detection axis A. For example, an upper surface 110 of the supporting element 86 of the sensor 70 can be arranged in abutment against a lower surface 112 of a body 114 which rests against an upper surface 116 of the wall 50.

The injector 10 may comprise at least one elastic element 102, formed, for example, by a cup spring, coaxial with the detection axis A and arranged to apply an elastic force in the direction of the detection axis A between the sensor 70 and the diaphragm 120. The elastic element 102 and the sensor 70 are arranged so that in the direction of the detection axis A the sensor 70 is only subject to the elastic force produced by the elastic element 102.

In the example illustrated, the elastic element 102 is axially compressed between the second surface 124 of the diaphragm 120 and a lower surface 104 of the supporting element 84. The supporting element 84 may have an axial protrusion 106 protruding from the lower surface 104 in the direction of the detection axis A, and which engages a central hole 108 of the elastic element 102. The elastic element 102 compresses the sensor 70 in the direction of the detection axis A against the lower surface 112 of the body 114.

The sensor 70 generates an electrical signal related to the elastic force that the elastic element 102 applies along said detection axis A between the piezoelectric sensor 70 and the diaphragm 120. During operation, the cyclic pressure variations of the fluid in the hydraulic chamber 34 cause cyclic deformations of the diaphragm 120 in the direction of the detection axis A. The deformations of the diaphragm 120 caused by the variations in pressure of the fluid cause deformations in the direction of the detection axis A of the second surface 124 of the diaphragm 120. The deformations of the second surface 124 in the direction of the detection axis A - in turn - cause variations in the elastic force that the elastic element 102 applies to the sensor 70 and, therefore, a variation of the electrical signal generated by the sensor 70. The electrical signal generated by the sensor 70 is, therefore, directly related to the instantaneous value of the pressure of the fluid contained in the hydraulic chamber 34.

The forces due to the deformation of the diaphragm 120 are transmitted to the sensor only by means of the elastic element 102 and this prevents deformation of the diaphragm 120 (under the action of the pressure in the hydraulic chamber 34) generating excessive loads on the sensor 70.

The rigidity of the elastic element 102 is sized according to the thickness of the diaphragm 120 and the pressure in the hydraulic chamber 34. By means of an appropriate choice of the dimensions and geometry of the elastic element 102, the rigidity of the elastic element 102 can be adapted so that the deformation of the diaphragm 120 generates a force compatible with the working range of the piezoelectric elements 78, 80.

The possibility of varying the rigidity of the elastic element 102 at the design stage allows an adequate thickness of the diaphragm 120 to be guaranteed.

In the case in which both disc-shaped elements 78, 80 are piezoelectric elements, the facing and opposite arrangement of the piezoelectric elements 78, 80 doubles the sensitivity of the sensor 70 with respect to a sensor that uses a single piezoelectric element, and simplifies its construction since it uses the same piezoelectric elements 78, 80 as electrical insulation elements between the positive pole and the negative pole and avoids the introduction of further elements of insulating material into the stack of elements that support the load to which the sensor 70 is subject.

The sensor 70 has very small dimensions and can be easily housed between the calibrated orifices 36, 44 of the wall 50. The sensor 70 is capable of providing an indirect measurement of the hydraulic pressure in the hydraulic chamber 34 without any contact with the fluid and without modifying the geometry of the hydraulic chamber 34 in any way. The deformations of the diaphragm 120 can be detected by the sensor 70 with an excellent signal/noise ratio.

The hydraulic pressure inside the hydraulic chamber 34 detected by the sensor 70 can be processed to obtain diagnostic information on the operation of the injector 10.

The drawings illustrate, by way of example, application of the sensor 70 according to the present invention in a common-rail injector. However, it is understood that the sensor 70 according to the present invention can be used in high pressure hydraulic systems of any other type, such as, for example, accumulators, pipes, pumps, valve elements, etc.

In general, the sensor 70 can be mounted in any component of a hydraulic system having a surface exposed to a pressurized fluid, and which deforms due to changes in the pressure of the fluid.

The sensor 70 is, therefore, able to detect the pressure of the fluid without direct contact with the pressurized fluid, thanks to the deformations of the diaphragm that separates the sensor 70 from the volume containing the pressurized fluid.

The elastic element 102 could be arranged differently from that illustrated in the drawings, provided that the sensor 70 in the direction of the detection axis A is only subject to the action of the elastic force produced by the elastic element 102. For example, the elastic element could be arranged between the surface 112 of the body 114 and the upper surface 110 of the second supporting element 84.

Of course, without prejudice to the principle of the invention, the details of construction and the embodiments can be widely varied with respect to those described and illustrated, without thereby departing from the scope of the invention as defined by the claims that follow.

## Claims

1. A high pressure hydraulic system comprising:
- a hydraulic chamber (34) containing pressurized fluid,
- a wall (50) which encloses at least one part of the hydraulic chamber (34) and comprising an integral diaphragm (120),
- a piezoelectric sensor (70) isolated from the pressurized fluid contained in the hydraulic chamber (34) by said diaphragm (120) and having a detection axis (A), wherein the piezoelectric sensor (70) generates an electrical signal related to a force that compresses the piezoelectric sensor (70) along the detection axis (A), and **characterized in that** the high pressure hydraulic system further comprises :
- an elastic element (102) arranged to apply an elastic force along said detection axis (A) between the piezoelectric sensor (70) and the diaphragm (120), wherein the elastic element (102) and the sensor (70) are arranged so that a deformation of the diaphragm (120) in the direction of the detection axis (A) produced by a variation of the pressure of the fluid contained in the hydraulic chamber (34) causes a variation of the elastic force that the elastic element (102) applies along the detection axis (A) between the piezoelectric sensor (70) and the diaphragm (120).

2. A hydraulic system according to claim 1, wherein the elastic element (102) and the piezoelectric sensor (70) are arranged so that in the direction of the detection axis (A) the sensor (70) is only subject to the elastic force produced by the elastic element (102) .

3. A hydraulic system according to claim 1 or claim 2, wherein said diaphragm (120) is formed by a portion with reduced thickness of said wall (50).

4. A hydraulic system according to claim 3, wherein said diaphragm (120) is located at the bottom of a blind hole (72) formed in said wall (50) and in which said piezoelectric sensor (70) is housed.

5. A hydraulic system according to any one of the preceding claims, wherein said piezoelectric sensor (70) comprises:
- two disc-shaped elements (78, 80) having respective first faces (78', 80') and respective second faces (78", 80") parallel to each other and perpendicular to the detection axis (A), wherein at least one of said disc-shaped elements (78, 80) is a piezoelectric element,
- an electrode (82) formed by a thin plate of conductive material, which is perpendicular to the detection axis (A), wherein the first faces (78', 80') of the two disc-shaped elements (78, 80) are in contact with opposite faces of the electrode (82),
- two supporting elements (84, 86) of electrically-conductive material with respective supporting faces (88, 90) resting against respective second faces (78", 80") of the disc-shaped elements (78, 80).

6. A hydraulic system according to claim 5, wherein said elastic element (102) is compressed in the direction of the detection axis (A) between said diaphragm (120) and one surface (104) of said supporting elements (84).

7. A hydraulic system according to claim 5, wherein the piezoelectric sensor (70) comprises an annular-shaped insulating element (96), arranged coaxially with the detection axis (A) on the outside of the electrode (82), wherein the insulating element (96) has an inner surface (98) facing the outer edges of the disc-shaped elements (78, 80) and the electrode (82).

8. A hydraulic system according to claim 7, wherein the insulating element (96) has a dimension in the direction of the detection axis (A) that is less than the distance between the supporting faces (88, 90) of the supporting elements (84, 86), and has a base surface (100) that rests on the outer perimeter part of the supporting face (88) of one supporting element (84) .

9. A hydraulic system according to claim 5, wherein both said disc-shaped elements (78, 80) are piezoelectric elements, and wherein the first faces (78', 80') of the disc-shaped elements (78, 80) are positive terminal faces and the second faces (78", 80") of the disc-shaped elements (78, 80) are negative terminal faces.

10. A hydraulic system according to claim 5, wherein one of said supporting elements (84) has an axial projection (106) that protrudes from a surface (104) opposite the respective supporting face (88) in the direction of the detection axis (A) and that engages a central hole (108) of the elastic element (102).

## Patentansprüche

1. Hochdruck-Hydrauliksystem, umfassend:
- eine Hydraulikkammer (34), die unter Druck stehendes Fluid enthält,
- eine Wand (50), die mindestens einen Teil der Hydraulikkammer (34) umschließt und ein integriertes Diaphragma (120) umfasst,
- einen piezoelektrischen Sensor (70), der durch das Diaphragma (120) gegenüber dem in der Hydraulikkammer (34) enthaltenen unter Druck stehenden Fluid isoliert ist und eine Erfassungsachse (A) aufweist, wobei der piezoelektrische Sensor (70) ein elektrisches Signal erzeugt, das mit einer Kraft in Beziehung steht, die den piezoelektrischen Sensor (70) entlang der Erfassungsachse (A) komprimiert, und
**dadurch gekennzeichnet, dass** das Hochdruck-Hydrauliksystem ferner Folgendes umfasst:
- ein elastisches Element (102), das dafür eingerichtet ist, eine elastische Kraft entlang der Erfassungsachse (A) zwischen dem piezoelektrischen Sensor (70) und dem Diaphragma (120) auszuüben, wobei das elastische Element (102) und der Sensor (70) so eingerichtet sind, dass eine durch eine Änderung des Drucks des in der Hydraulikkammer (34) enthaltenen Fluids verursachte Verformung des Diaphragmas (120) in Richtung der Erfassungsachse (A) eine Änderung der elastischen Kraft bewirkt, die das elastische Element (102) entlang der Erfassungsachse (A) zwischen dem piezoelektrischen Sensor (70) und dem Diaphragma (120) ausübt.

2. Hydrauliksystem nach Anspruch 1, wobei das elastische Element (102) und der piezoelektrische Sensor (70) so eingerichtet sind, dass in Richtung der Erfassungsachse (A) der Sensor (70) nur der durch das elastische Element (102) erzeugten elastischen Kraft ausgesetzt ist.

3. Hydrauliksystem nach Anspruch 1 oder Anspruch 2, wobei das Diaphragma (120) durch einen Abschnitt mit reduzierter Dicke der Wand (50) gebildet ist.

4. Hydrauliksystem nach Anspruch 3, wobei sich das Diaphragma (120) am Boden eines Sacklochs (72) befindet, das in der Wand (50) gebildet ist und in dem der piezoelektrische Sensor (70) aufgenommen ist.

5. Hydrauliksystem nach einem der vorhergehenden Ansprüche, wobei der piezoelektrische Sensor (70) Folgendes umfasst:
- zwei scheibenförmige Elemente (78, 80) mit jeweiligen ersten Stirnflächen (78', 80') und jeweiligen zweiten Stirnflächen (78", 80"), die parallel zueinander und senkrecht zu der Erfassungsachse (A) verlaufen, wobei es sich bei mindestens einem der scheibenförmigen Elemente (78, 80) um ein piezoelektrisches Element handelt,
- eine durch eine dünne Platte aus leitfähigem Material gebildete Elektrode (82), die senkrecht zu der Erfassungsachse (A) verläuft, wobei die ersten Stirnflächen (78', 80') der zwei scheibenförmigen Elemente (78, 80) mit entgegengesetzten Stirnflächen der Elektrode (82) in Kontakt stehen,
- zwei Stützelemente (84, 86) aus elektrisch leitfähigem Material, deren jeweilige Stützflächen (88, 90) an jeweiligen zweiten Stirnflächen (78", 80") der scheibenförmigen Elemente (78, 80) anliegen.

6. Hydrauliksystem nach Anspruch 5, wobei das elastische Element (102) in Richtung der Erfassungsachse (A) zwischen dem Diaphragma (120) und einer Fläche (104) der Stützelemente (84) komprimiert wird.

7. Hydrauliksystem nach Anspruch 5, wobei der piezoelektrische Sensor (70) ein ringförmiges Isolierelement (96) umfasst, das koaxial mit der Erfassungsachse (A) auf der Außenseite der Elektrode (82) angeordnet ist, wobei das Isolierelement (96) eine den Außenrändern der scheibenförmigen Elemente (78, 80) und der Elektrode (82) zugewandte Innenfläche (98) aufweist.

8. Hydrauliksystem nach Anspruch 7, wobei das Isolierelement (96) in Richtung der Erfassungsachse (A) eine Abmessung aufweist, die geringer ist als der Abstand zwischen den Stützflächen (88, 90) der Stützelemente (84, 86), und eine Grundfläche (100) aufweist, die auf dem äußeren Umfangsteil der Stützfläche (88) eines Stützelements (84) aufliegt.

9. Hydrauliksystem nach Anspruch 5, wobei es sich bei beiden scheibenförmigen Elementen (78, 80) um piezoelektrische Elemente handelt und wobei es sich bei den ersten Stirnflächen (78', 80') der scheibenförmigen Elemente (78, 80) um positive Anschlussflächen und bei den zweiten Stirnflächen (78", 80") um negative Anschlussflächen handelt.

10. Hydrauliksystem nach Anspruch 5, wobei eines der Stützelemente (84) einen axialen Vorsprung (106) aufweist, der von einer der jeweiligen Stützfläche (88) entgegengesetzten Fläche (104) aus in Richtung der Erfassungsachse (A) hervorsteht und der in ein zentrales Loch (108) des elastischen Elements (102) eingreift.

## Revendications

1. Système hydraulique haute pression comprenant :
- une chambre hydraulique (34) contenant un fluide sous pression,
- une paroi (50) qui entoure au moins une partie de la chambre hydraulique (34) et comprenant un diaphragme solidaire (120),
- un capteur piézoélectrique (70) isolé du fluide sous pression contenu dans la chambre hydraulique (34) par ledit diaphragme (120) et ayant un axe de détection (A), où le capteur piézoélectrique (70) génère un signal électrique relatif à une force qui comprime le capteur piézoélectrique (70) le long de l'axe de détection (A), et
**caractérisé en ce que** le système hydraulique haute pression comprend en outre :
- un élément élastique (102) agencé pour appliquer une force élastique le long dudit axe de détection (A) entre le capteur piézoélectrique (70) et le diaphragme (120), où l'élément élastique (102) et le capteur (70) sont agencés de sorte qu'une déformation du diaphragme (120) dans la direction de l'axe de détection (A) produite par une variation de la pression du fluide contenu dans la chambre hydraulique (34) provoque une variation de la force élastique que l'élément élastique (102) applique le long de l'axe de détection (A) entre le capteur piézoélectrique (70) et le diaphragme (120).

2. Système hydraulique selon la revendication 1, dans lequel l'élément élastique (102) et le capteur piézoélectrique (70) sont agencés de sorte que, dans la direction de l'axe de détection (A), le capteur (70) ne soit soumis qu'à la force élastique produite par l'élément élastique (102).

3. Système hydraulique selon la revendication 1 ou 2, dans lequel ledit diaphragme (120) est formé par une partie ayant une épaisseur réduite de ladite paroi (50).

4. Système hydraulique selon la revendication 3, dans lequel ledit diaphragme (120) est situé au fond d'un trou borgne (72) formé dans ladite paroi (50) et où ledit capteur piézoélectrique (70) est logé.

5. Système hydraulique selon l'une quelconque des revendications précédentes, dans lequel ledit capteur piézoélectrique (70) comprend :
- deux éléments en forme de disque (78, 80) ayant des premières faces respectives (78', 80') et des deuxièmes faces respectives (78", 80") parallèles entre elles et perpendiculaires à l'axe de détection (A), où au moins l'un desdits éléments en forme de disque (78, 80) est un élément piézoélectrique,
- une électrode (82) formée par une plaque mince de matériau conducteur, qui est perpendiculaire à l'axe de détection (A), où les premières faces (78', 80') des deux éléments en forme de disque (78, 80) sont en contact avec des faces opposées de l'électrode (82),
- deux éléments de support (84, 86) en matériau électriquement conducteur avec des faces de support respectives (88, 90) reposant contre des deuxièmes faces respectives (78", 80") des éléments en forme de disque (78, 80).

6. Système hydraulique selon la revendication 5, dans lequel ledit élément élastique (102) est comprimé dans la direction de l'axe de détection (A) entre ledit diaphragme (120) et une surface (104) desdits éléments de support (84).

7. Système hydraulique selon la revendication 5, dans lequel le capteur piézoélectrique (70) comprend un élément isolant de forme annulaire (96), agencé de manière coaxiale avec l'axe de détection (A) à l'extérieur de l'électrode (82), où l'élément isolant (96) a une surface interne (98) faisant face aux bords externes des éléments en forme de disque (78, 80) et de l'électrode (82).

8. Système hydraulique selon la revendication 7, dans lequel l'élément isolant (96) a une dimension dans la direction de l'axe de détection (A) qui est inférieure à la distance entre les faces de support (88, 90) des éléments de support (84, 86), et a une surface de base (100) qui repose sur la partie périphérique externe de la face de support (88) d'un élément de support (84).

9. Système hydraulique selon la revendication 5, dans lequel lesdits deux éléments en forme de disque (78, 80) sont des éléments piézoélectriques, et dans lequel les premières faces (78', 80') des éléments en forme de disque (78, 80) sont des faces terminales positives et les deuxièmes faces (78", 80") des éléments en forme de disque (78, 80) sont des faces terminales négatives.

10. Système hydraulique selon la revendication 5, dans lequel l'un desdits éléments de support (84) a une saillie axiale (106) qui fait saillie d'une surface (104) opposée à la face de support respective (88) dans la direction de l'axe de détection (A) et qui s'engage dans un trou central (108) de l'élément élastique (102).
